Europäisches Patentamt

European Patent Office

Office européen des brevets

(19)

(11) Publication number: 0 352 523
A2

(12) **EUROPEAN PATENT APPLICATION**

(21) Application number: 89112350.7

(51) Int. Cl.4: **G06F 15/60**

(22) Date of filing: 06.07.89

(30) Priority: 27.07.88 US 224640

(43) Date of publication of application:
31.01.90 Bulletin 90/05

(84) Designated Contracting States:
DE FR GB IT

(71) Applicant: MOTOROLA, INC.
1303 East Algonquin Road
Schaumburg Illinois 60196(US)

(72) Inventor: Jorvig, Jeffrey Richard
560 W. Myrna Lane
Chandler Arizona 85224(US)
Inventor: Smith, Trevor Sydney
5544 E. Evergreen Street
Mesa Arizona 85205(US)

(74) Representative: Holt, Michael et al
MOTOROLA European Intellectual Property
Operations Jays Close, Viables Ind. Est.
Basingstoke Hants, RG22 4PD(GB)

(54) Method of providing a layout for a data path block.

(57) A method for parameterizing a data path block
(11), that may be implemented in software for a
silicon compiler (50-60), provides a layout wherein
the data path elements such as latches, registers
multiplexers etc., all are designed having the same
pitch.

EP 0 352 523 A2

FIG. 3

# METHOD OF PROVIDING A LAYOUT FOR A DATA PATH BLOCK

### Field of the Invention

This invention relates in general to silicon compilers, and more specifically, to a method of generating a layout for a data path block.

### Background of the Invention

Historically, in designing Very Large Scale Integrated (VLSI) circuits, a team of systems designers laid out a multitude of logic circuits on paper. Integrated circuit system designers were a costly and scarce resource. Furthermore, the design could take more than a year, depending on the complexity and the number of semiconductor devices per chip. Computer Aided Design (CAD) techniques have greatly reduced both cost and time in the design of large chips by automating the drafting and placing of the semiconductor devices and logic functions.

Application Specific Integrated Circuits (ASIC) and hierarchical structured design methods have further reduced design time and costly effort. ASIC typically includes Programmed Logic Devices (PLD), gate arrays (bipolar and BIMOS technologies), and standard cells (CMOS technology).

The PLD designer creates a truth table, or state table if the circuit is sequential, from the logic problem. A software program converts the table into a Boolean equation, whereby a compiler creates a fuse map. The fuses of the PLD are then "burned" on the chip in accordance with the fuse map.

Gate arrays are mainly pre-processed wafers with macrocells which are similar to familiar standard logic functions. A designer calls up these macrocells from a software library on a CAD system. The designer thereby designs the gate array by placing the macrocells in the desired location with appropriate interconnections. The benefits are increased silicon efficiency and consequently higher logic densities and lower costs.

Standard cells use silicon area even more efficiently than gate arrays, but conventionally have required more design time. Standard cells constitute a library of functions ranging from primitive functions such as AND and OR gates to more complex functions such as random access memory (RAM) and read only memory (ROM). The Standard Cell designer designed his system using the pre-defined library of functions, creating a pattern generation tape which digitized the layout of the chip. This tape would then be used to create the masks for manufacturing the chip.

However, fairly recent advances in computer technology have created a hierarchical structured design methodology. This methodology uses a computer system called "silicon compiler" or "silicon generator" for creating and laying out an integrated circuit design. The silicon compiler typically takes a high level description of the system and converts it into a parameterized layout of the circuit. Although the initial preparation of the design software may consume a lengthy time period, subsequent circuit design for multiple circuits require substantially less time. Building blocks within the silicon compiler for structuring functional blocks, or files, include data path generators, state machine compilers, and PLA compilers.

The silicon compiler generates the major building blocks and places them. Then it routes interconnections between the building blocks, optimizing the interconnections for multiple variables such as speed, gate count, or area. A back-annotated netlist containing the timing of the circuit is passed back to the designer so he can resimulate the design to meet his goals. Then the designer adjusts the layout or replaces components in a critical path to achieve the desired performance.

It is important that the software for each file provide an efficient method for generating the desired result for that file so that the hierarchical software will provide the most efficient end result. Complex blocks at a given level in the hierarchical structure call upon less complex blocks at a lower level in the hierarchical structure for creating the desired element. Furthermore, it may be desired to have several of these elements provided in a data path for performing desired logic on the input signals. These elements in a data path may comprise latches, registers, incrementers, adders, multiplexers, etc., that manipulate a plurality of input bits. Although methods of generating a layout for individual elements are known (see references cited above), a method for combining these elements in a data path that minimizes area has not been previously disclosed.

Thus, what is needed is a method of generating a design for a data path block, that interfaces with the hierarchical method of the silicon compiler.

### Summary of the Invention

Accordingly, it is an object of the present invention to provide a method for generating a design for a data path block within a silicon compiler.

Another object of the present invention is to provide a method of parameterizing a data path block within a silicon compiler.

In carrying out the above and other objects of the invention in one form, there is provided a method for providing the layout of a data path block, the data path block including a plurality of data path elements, each of the data path elements having a control section and a plurality of data path sections, the method comprising the steps of initializing the environment; measuring the pitch for the control sections and data path sections of each of the data path elements; calculating the pitch and routing track locations for the control section and data path sections for each of the data path elements; building and routing metal interconnects within each of the data path elements; placing the data path elements; and placing the metal interconnects between data path elements.

The above and other objects, features, and advantages of the present invention will be better understood from the following detailed description taken in conjunction with the accompanying drawings.

Brief Description of the Drawing

FIG. 1 is a a block diagram of a typical data path block.

FIG. 2 is a top plan view of an integrated circuit including a typical element of a data path block.

FIG. 3 is a top plan view of an integrated circuit including a typical data path block.

FIG. 4 is a schematical representation of a silicon compiler.

FIG. 5 is a flow chart illustrating a sequence of steps to be followed in designing a data path block in accordance with the present invention.

FIGs. 6 and 7 are a more detailed flow chart of the method in the flow chart illustrated in FIG. 5.

Detailed Description of the Invention

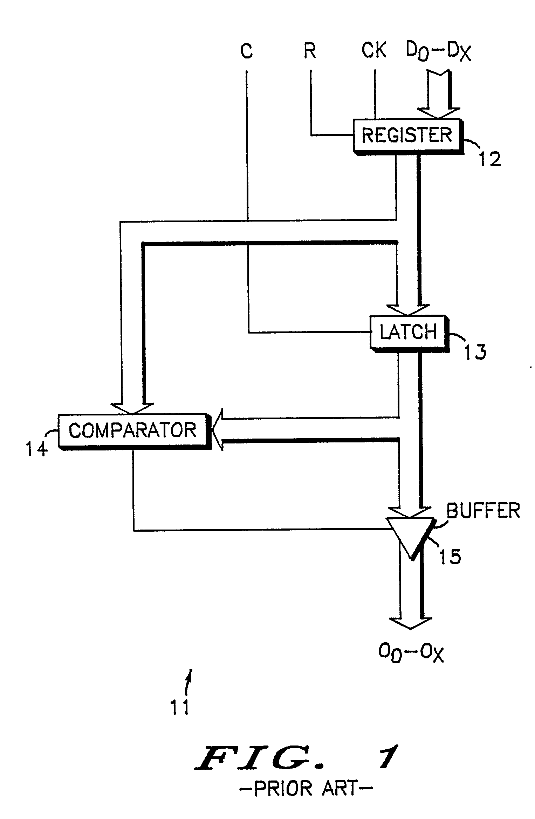

Referring to FIG. 1, a data path block 11 includes a register 12 coupled to receive a data signal D having "x" number of bits, a clock signal CK and a reset signal R, and coupled to provide the data signal D to a latch 13 and a comparator 14. The latch 13 is also coupled to receive a clock signal C and is coupled to provide the data signal D to the comparator 14 and a buffer 15. The comparator 14 connected to the buffer 15 for enabling the buffer 15 in response to the data signal received from the register 12 and the latch 13. The buffer 15 provides the data signal D as an output $O_0 - O_x$ of the data path block 11 after having been manipulated by register 12, latch 13, comparator 14 and buffer 15.

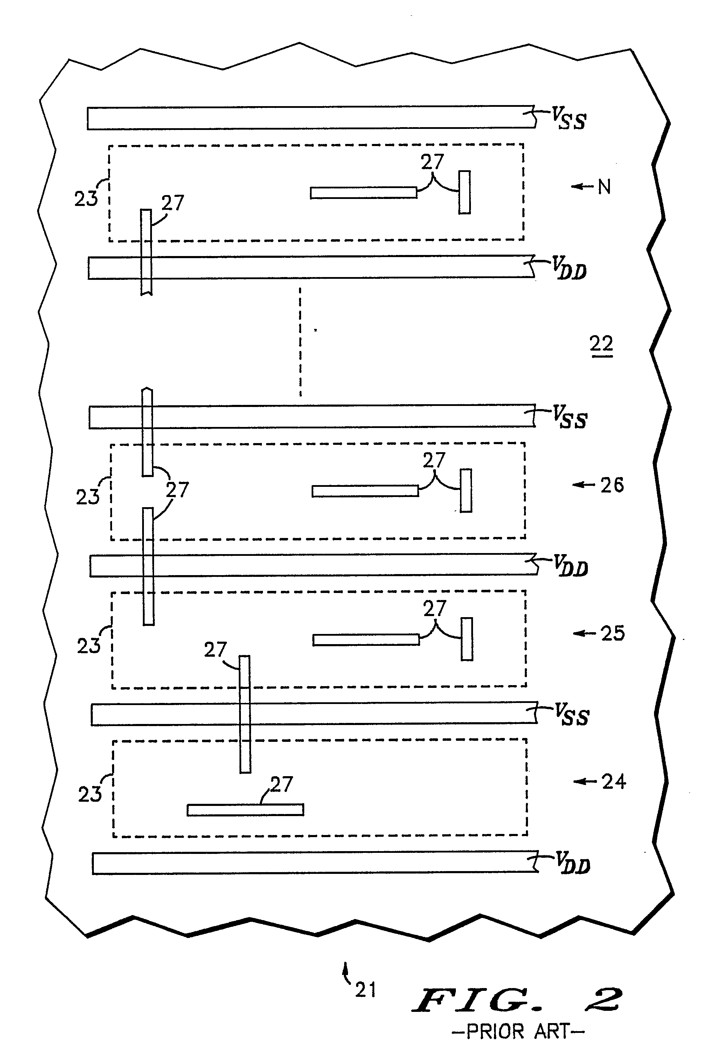

Referring to FIG. 2, a latch 21 typical of one of the elements of a data path block is partially illustrated in a top plan view of an integrated circuit 22 including a plurality of semiconductor devices 23, a control, or clock, section 24 and a plurality of bit sections 25, 26, ..., N. The number of bit sections n depends on the number of digital bits or input bits for the particular application desired. Supply voltage metallization strips $V_{SS}$ and $V_{DD}$ alternate between the control and bit sections for supplying voltages thereto. Metallization strips 27 overlie the control section 24 and bit sections 25, 26, ..., N for connecting semiconductor devices 23 together both within each section and between sections as appropriate. Although only a few metallization strips 27 are illustrated for explanation, several more would be required for the actual circuit. Additionally, several more latches or other circuits would typically exist on integrated circuit 22.

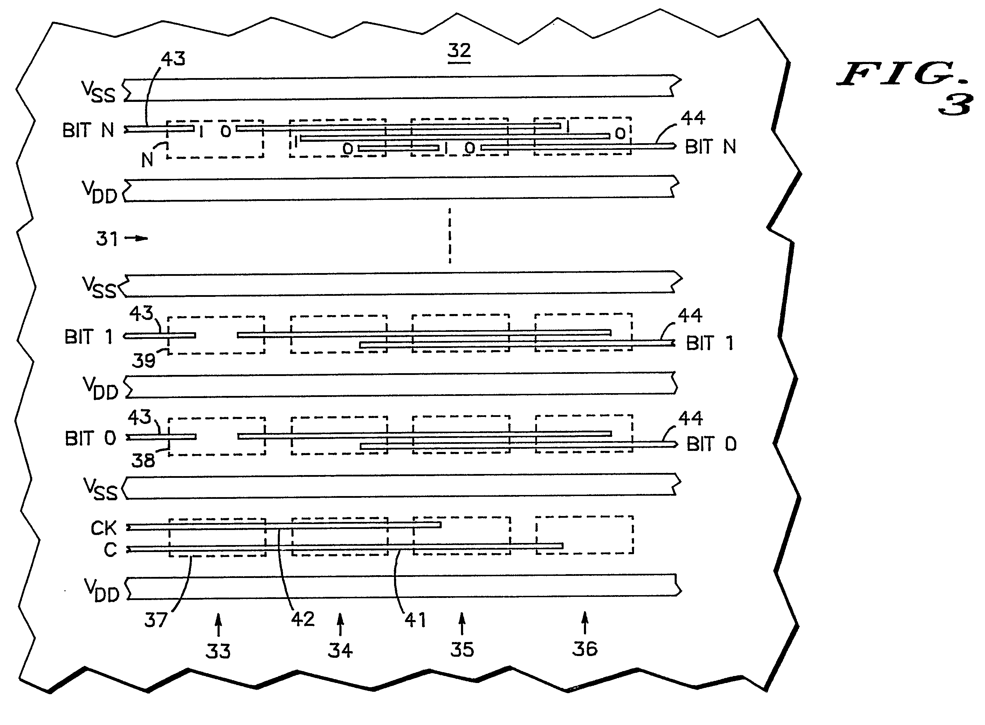

Referring to FIG. 3, a data path block 31 is partially illustrated in a top plan view of an integrated circuit 32 including elements 33, 34, 35 and 36. Elements 33, 34, 35 and 36 may each comprise one of any of a number of logic circuits such as a latch, register, incrementer, adder or multiplexer. There may be any number of elements in the data path block 31; however, only four are shown as an example. Each element 33, 34, 35 and 36 comprises a control section 37 and a plurality of data bit sections 38, 39 through N. Clock signals C and CK are provided to selected ones of the control sections 37 of the elements 33, 34, 35 and 36 by metallization 41 and 42, respectively. For example, the clock signal C may be provided to the control sections 37 of elements 34 and 36, and the clock signal CK may be provided to the control sections 37 of elements 33 and 35. A bit N input signal is provided to the data bit sections 38, 39 through N by metallization 43. The data bit 1 through bit N are transmitted between data bit sections of each element 33, 34, 35 and 36 by the metallization coupled therebetween and provided as an output of the data path block 31 at metallization 44. Although only a few metallization strips are illustrated for explanation, several more would be required for the actual circuit.

The control section 37 provides clock signals C and CK for clocking bit sections 38, 39 through N. The bit sections 38, 39 through N and the control section 37 may be designed using standard cell (ASIC) methodologies. The method described herein is a way of providing a layout of the latch in silicon with the accompanying metallization in an efficient manner.

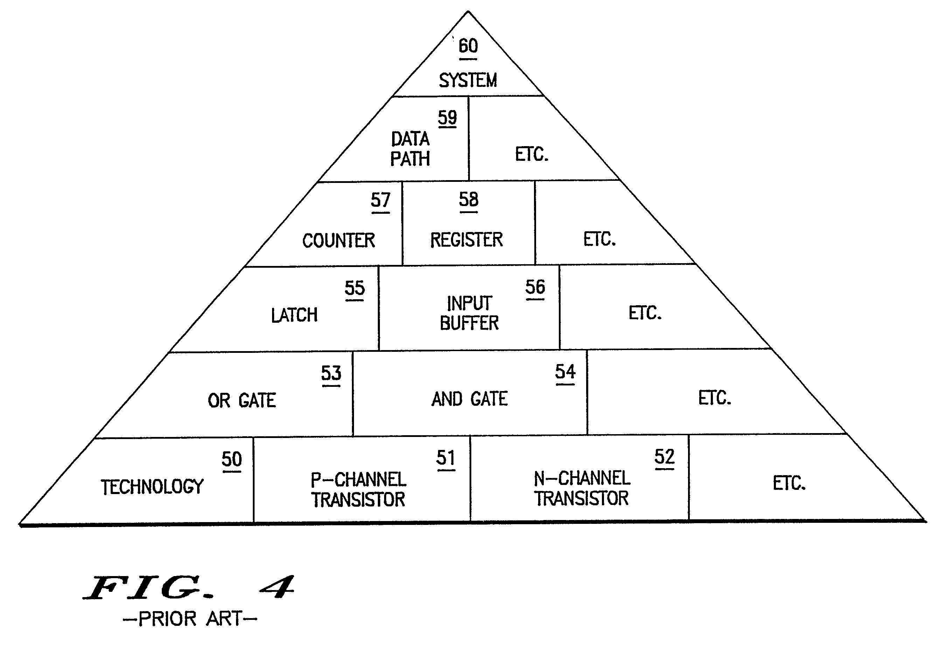

The hierarchical approach used by silicon compilers is illustrated by way of example in FIG. 4. Hierarchical software encompassing the entire triangle of the figure interfaces with software for each functional block, or file, of the figure. The first level contains software relating to basics such as technology 50, a P-channel transistor 51, and an N-channel transistor 52. For example, the technology file 50 describes information such as material type (P+) dimensions, layout rules, and process parameters and the transistor blocks 51 and 52 describe information such as dimensions.

The second level contains files relating to primitives such as an OR gate 53 and an AND gate 54. The third level contains files relating to more complex circuits such as a latch 55 and an input buffer 56. The fourth level contains files relating to still more complex circuits such as a counter 57 and a register 58. The sixth level contains a file relating to a data path block 59. The seventh contains a file describing the system 60 desired. The diagram shown is only used by way of example. An actual silicon compiler may comprise many more levels and would have many files within each level.

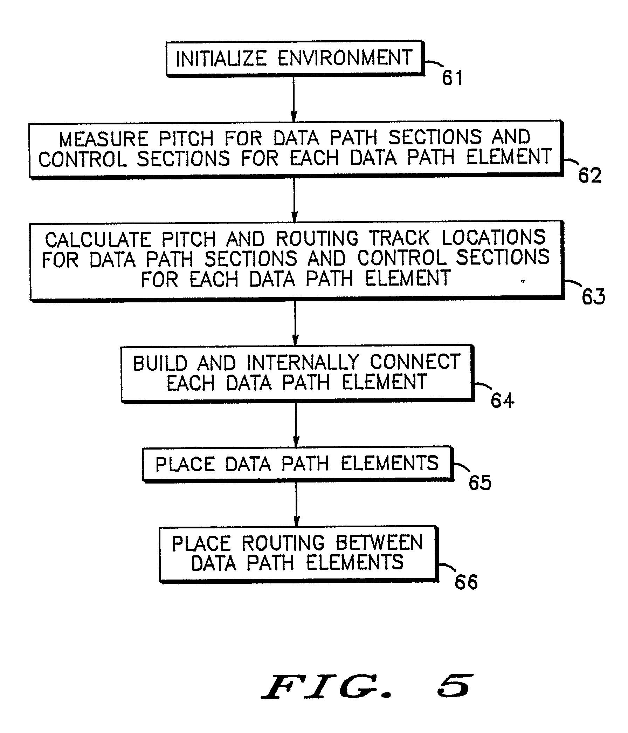

Referring to FIG. 5, and in accordance with the present invention, a flow chart for the steps of the present invention is illustrated that provides a layout for a data path block. This method may be implemented in software, written for example in the language "L", that interfaces with the hierarchical software of a compiler as illustrated in FIG. 4 and would provide the data path block 59 illustrated in the fifth level of FIG. 4. This method would be useful with any technology 50 as well as any hierarchical software. Step 61 initializes the environment. This comprises accessing layout rules stored in the technology file 50, setting a variable for accessing cell parameters which are stored in a separate file, setting global variables for pitch matching, setting an index to dictate the flow of steps, and storing cell parameters that have been provided as an input. Step 62 measures the pitch for the data path sections 38, 39 through N and for the control sections 37 for each data path element 33, 34, 35 and 36. This comprises accessing a data file which contains information regarding semiconductor device sizes, location of input and output ports, and the number of routing tracks (metallization); and determining the pitch that would be required to build the data path sections 38, 39 through N and control sections 37. Pitch is the periodic distance between each repeating element of the design. Step 63 calculates pitch and routing track locations for the data path sections 38, 39 through N and for control sections 37 which will be the pitch of the tallest cell measured after each section is measured. This calculates the specific placements for transistors and their interconnection tracts. Step 64 builds and internally connects the control sections 37 and data path sections 38, 39 through N separately for each of the data path elements 33, 34, 35 and 36. This comprises accessing the data file which contains specific information about how to build the cell primitive, and for both the data path sections 38, 39 through N and control section 37, placing each of the logic gates required to make the data path elements 33, 34, 35 and 36 one at a time in a layout of the data path block 31. All of the data path elements 33, 34, 35 and 36 will be built with the same pitch, which is defined by the tallest element in the data path. Step 65 places the data path elements 33, 34, 35 and 36. Step 66 connects the elements 33, 34, 35 and 36 by placing the metallization coupled therebetween.

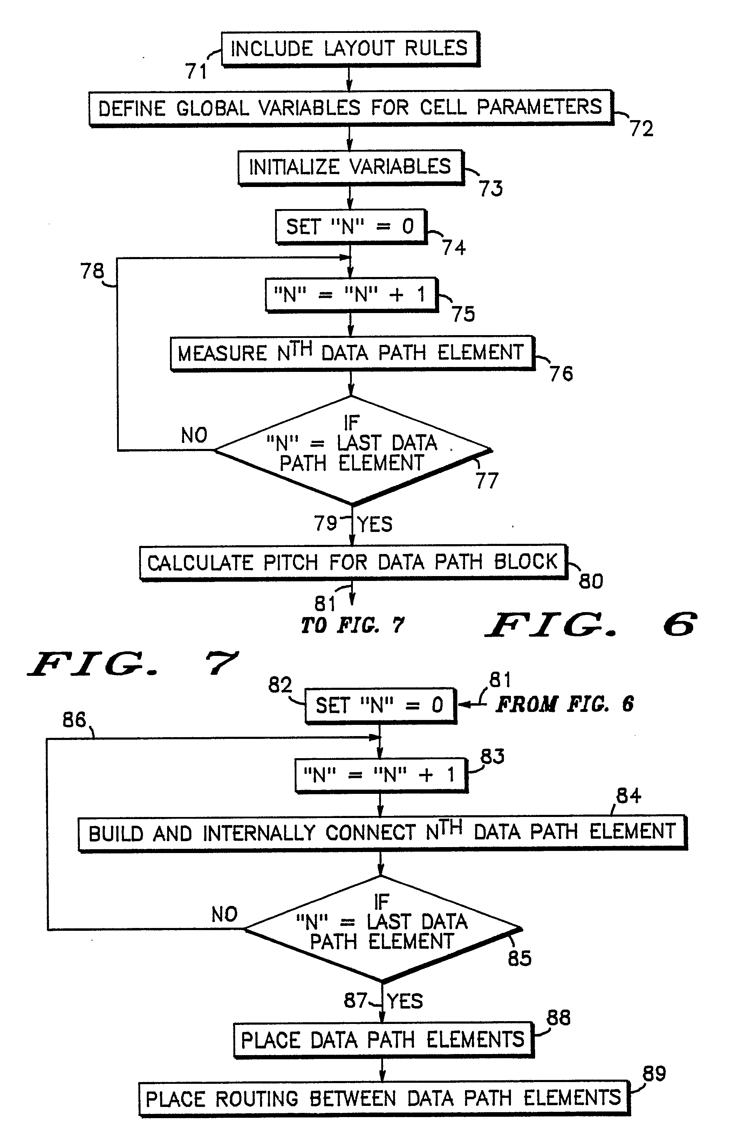

FIGs. 6 and 7 provide a more detailed diagram of the steps of the method illustrated in FIG. 5, wherein step 61 includes steps 71-73 of FIG. 6, step 62 includes steps 7477 of FIG. 6, step 63 includes steps 80 of FIG. 6, step 64 includes steps 82-85 of FIG. 7.

Referring to FIG. 6, step 71 defines variables for the layout rules of technology block 50 such as metal to metal spacing and metal overlap of contacts. Step 72 defines global variables for data path element parameters. These include, for example, number of data path sections, whether triggered on an active high or an active low, placement of input/output on specific metal layer, D input track location, Q output track location, and clock input CI track location. Step 73 initializes variables for pitch matching by declaring them and setting them to zero. These variables will be maximized to the tallest primitive needed within the cell during measurement. Step 74 sets the index "N" to the value 0 and step 75 redefines "N" as "N" + 1 for defining the mode of operation (dictates a path for the flow chart). Step 76 measures a data path element 33, 34, 35 and 36 as determined by the value of "N". Step 77 branches the path along path 78 if the last data path element 33, 34, 35 and 36 has not been measured and along path 79 if all of the data path elements 33, 34, 35 and 36 have been measured. Step 80 calculates the pitch for the data path block.

Step 82 resets "N" to 0 and step 83 defines "N" to be "N" + 1. Step 84 builds and internally connects each data path element 33, 34, 35 and 36 and places the metallization within each data path element 33, 34, 35 and 36 to define the specific logic function (i.e., latch, register, etc.) for each data path element 33, 34, 35 and 36. Step 85 branches the path along path 86 if the last data path element 33, 34, 35 and 36 has not been built and along path 87 if all of the data path elements 33, 34, 35 and 36 have been built. Step 88 places the data path elements. Step 89 places the metallization between each of the data path elements 33, 34, 35 and 36.

By now it should be appreciated that there has been provided a method of generating a design for a data path block that interfaces with the hierarchical method of the silicon compiler.

## Claims

1. An apparatus for providing the layout of a data path block (11), the data path block (11) including a plurality of data path elements, each of the data path elements (33-36) having a control section (37) and a plurality of data path sections (38, 39) and sucessively performing a logic function on a data signal having a plurality of bits, each of the data path sections performing a logic function on one bit of the data signal, said apparatus comprising:
first means (61) for initializing the environment;
second means (62) coupled to said first means for measuring the pitch for said control sections and data path sections for each of said data path elements;
third means (63) coupled to said second means for calculating the pitch for said control sections and data path sections for each of said data path elements;
fourth means (64) coupled to said third means for both building and routing metal interconnects within each of said data path elements;
fifth means (65) coupled to said fourth means for placing data path elements; and
sixth means (66) coupled to said fifth means for placing the metal routing between said data path elements.

2. The apparatus according to claim 1 wherein said second means comprises:
seventh means (76) coupled to said second means for measuring the control section and data path sections of one data path element; and
eighth means (75-78) coupled to said second means for measuring the control sections and data path elements in succession.

3. 'The apparatus according to claim 2 wherein said fourth means comprises:
ninth means (84) coupled to said third means for building the control section and data path sections of one data path element; and
tenth means (83 - 86) coupled to said ninth means for building the control sections and data path elements in succession.

C  R  CK  $D_0-D_X$

REGISTER — 12

LATCH — 13

COMPARATOR
14

BUFFER
15

$O_0-O_X$

11

# FIG. 1
-PRIOR ART-

*FIG. 2*

−PRIOR ART−

FIG. 3

EP 0 352 523 A2

FIG. 4

—PRIOR ART—

```
┌─────────────────────────┐
│  INITIALIZE ENVIRONMENT  │──┐
└─────────────────────────┘  61
            │
            ▼
┌───────────────────────────────────────────┐
│  MEASURE PITCH FOR DATA PATH SECTIONS AND   │
│ CONTROL SECTIONS FOR EACH DATA PATH ELEMENT │──┐
└───────────────────────────────────────────┘  62
            │
            ▼
┌───────────────────────────────────────────┐
│ CALCULATE PITCH AND ROUTING TRACK LOCATIONS │
│ FOR DATA PATH SECTIONS AND CONTROL SECTIONS │
│         FOR EACH DATA PATH ELEMENT          │──┐
└───────────────────────────────────────────┘  63
            │
            ▼
┌───────────────────────────────┐
│  BUILD AND INTERNALLY CONNECT   │
│     EACH DATA PATH ELEMENT      │──┐
└───────────────────────────────┘  64
            │
            ▼
┌───────────────────────────────┐
│    PLACE DATA PATH ELEMENTS     │──┐
└───────────────────────────────┘  65
            │
            ▼
┌───────────────────────────────┐
│    PLACE ROUTING BETWEEN        │
│      DATA PATH ELEMENTS         │──┐
└───────────────────────────────┘  66
```

# FIG. 5

INCLUDE LAYOUT RULES

71

DEFINE GLOBAL VARIABLES FOR CELL PARAMETERS 72

INITIALIZE VARIABLES 73

SET "N" = 0 74

78

"N" = "N" + 1 75

MEASURE NTH DATA PATH ELEMENT 76

NO

IF "N" = LAST DATA PATH ELEMENT 77

79 YES

CALCULATE PITCH FOR DATA PATH BLOCK 80

81

*TO FIG. 7*     *FIG. 6*

*FIG. 7*

82   SET "N" = 0   81 *FROM FIG. 6*

86

"N" = "N" + 1 83

84

BUILD AND INTERNALLY CONNECT NTH DATA PATH ELEMENT

NO

IF "N" = LAST DATA PATH ELEMENT 85

87 YES

PLACE DATA PATH ELEMENTS 88

89

PLACE ROUTING BETWEEN DATA PATH ELEMENTS